# EUROPÄISCHE PATENTSCHRIFT

(11) **EP 3 117 511 B1**
(45) Veröffentlichungstag und Bekanntmachung des Hinweises auf die Patenterteilung: **16.12.2020**
(21) Anmeldenummer: 14722617.9
(22) Anmeldetag: 25.04.2014
(51) Int. Cl.: H02M 1/32, H02H 7/122, H02H 7/125, H02M 7/483

(54) **VERFAHREN ZUR ERKENNUNG EINES ZUSAMMENBRUCHS EINER SPANNUNG**
METHOD FOR DETECTING A VOLTAGE COLLAPSE
PROCÉDÉ D'IDENTIFICATION DE L'EFFONDREMENT D'UNE TENSION

(43) Veröffentlichungstag der Anmeldung: 18.01.2017
(73) Patentinhaber: Siemens Aktiengesellschaft, 80333 München (DE)
(72) Erfinder: ERMISCH, Ronny, 90768 Fürth (DE); LASSOUED, Nizar, 91052 Erlangen (DE); SCHUSTER, Dominik, 91456 Diespeck (DE)
(86) Internationale Anmeldenummer: PCT/EP2014/058494
(87) Internationale Veröffentlichungsnummer: WO 2015/161893

(56) Entgegenhaltungen:
- US-A1- 2008 232 145
- Patrick J. Kelly: "Chapter 6: Pulse-Charging Battery Systems", , 12. März 2014 (2014-03-12), Seiten 1-52, XP055158756, Gefunden im Internet: URL:http://www.free-energy-info.com/Chapte r6.pdf [gefunden am 2014-12-15]

## Beschreibung

Die Erfindung betrifft ein Verfahren zur Erkennung eines Zusammenbruchs einer Arbeitsspannung über einem elektrischen Bauelement, bei dem die Arbeitsspannung auf das Übertreten eines kritischen Charakteristikums überwacht und ein Übertreten als Zusammenbruch erkannt wird.

Durch die verstärkte Einspeisung von erneuerbaren Energien in Stromnetze bekommt die Hochspannungs-Gleichstrom-Übertragung (HGÜ) eine immer größere Bedeutung. Insbesondere beim Offshore-Windparks wird eine strahlungsarme und kostengünstige Kabelverbindung bevorzugt, die durch die HGÜ-Technik realisierbar ist. Da in Offshore-Windparks kein stabiles Netz vorhanden ist, bietet insbesondere die selbstgeführte HGÜ den Vorteil, dass sie geregelte Blindleistung Offshore zur Verfügung stellt. Außerdem kann mit selbstgeführter HGÜ das dynamische Verhalten am Anschlussknoten verbessert werden.

Kernelemente der Anschlüsse vom Windparknetz an die HGÜ und von der HGÜ an große Festlandtrassen bilden selbstgeführte HGÜ-Umrichter mit Spannungszwischenkreis und Transistoren, insbesondere IGBT (Insulated Gate Bipolar Transistoren). Die Möglichkeit, Wirk- und Blindleistung unabhängig voneinander regeln zu können, erleichtert den Anschluss selbstgeführter Umrichter an Drehstromnetze mit kleiner Kurzschlussleistung. Auch der Betrieb von Inselnetzen ist möglich, da der Netzaufbau, der sogenannte black-start, vereinfacht ist. Selbstgeführte HGÜ-Umrichter sind mit großen Gleichstrom-Kondensatoren ausgestattet, die zur Stütze der umgerichteten Spannung dienen. Die Umspannung von Drehstrom in Gleichstrom oder andersrum erfolgt durch die Schaltung von in der Regel zwei in Reihe geschalteten IGBT, zwischen denen der Wechselstrom abzweigt.

Bei einem Schaltfehler eines selbstgeführten HGÜ-Umrichters kann es zu einer schlagartigen Entladung der im Gleichstrom-Kondensator enthaltenen Energie über die Schalter kommen. Die hierbei freigesetzte Energie führt zu einer Zerstörung der Schalter und damit des Umrichters.

Die US 2008/0232145 A1 beschreibt ein Verfahren zum Schutz eines Umrichtermoduls, bei dem das Umrichtermodul mittels einer Schutzschaltung, die an dessen Ausgangsklemmen angeordnet ist, in einem Fehlerfall kurzgeschlossen wird.

Ein weiteres Verfahren zum Überwachen einer Arbeitsspannung ist aus dem Beitrag von Patrick J. Kelly: "Chapter 6: Pulse-Charging Battery Systems" bekannt.

Es ist eine Aufgabe der vorliegenden Erfindung, ein Verfahren zur Erkennung eines Zusammenbruchs einer Arbeitsspannung anzugeben, mit dem der Schaden an einem Umrichter bei einem Schaltfehler begrenzt werden kann.

Diese Aufgabe wird durch ein Verfahren der eingangs genannten Art gelöst, bei dem eine von einer Modellschaltung erzeugten Modellspannung als kritisches Charakteristikum verwendet wird.

Die Erfindung geht von der Überlegung aus, dass es vorteilhaft ist, einen Umrichter im Fehlerfall sicher zu überbrücken beziehungsweise auszuschalten. Dies kann durch einen Bypass geschehen, der beispielweise gezündet und damit geschlossen wird. Ein Zündkriterium kann der Kurzschluss beziehungsweise Zusammenbruch der Arbeitsspannung über dem Kondensator des Umrichters sein. Der Zusammenbruch der Arbeitsspannung über den Kondensator kann überwacht werden, indem der Abfall, also die negative Steigung, der Arbeitsspannung über die Zeit, also der Spannungsgradient bzw. du/dt, überwacht wird. Überschreitet der Abfall einen Grenzwert, so kann dies als Hinweis für einen Zusammenbruch der Arbeitsspannung erkannt werden. Eine solche Überwachung ist jedoch fehleranfällig, insbesondere bei starken und sehr kurzzeitigen Spannungsschwankungen, die nicht durch einen Spannungszusammenbruch hervorgerufen wurden.

Dieses Problem kann durch die Erfindung behoben werden. Es wird nicht der Spannungsgradient als solcher überwacht, sondern die Tatsache, ob der Verlauf der Arbeitsspannung die Modellspannung übertritt. Eine kurzzeitige negative Gradientenspitze kann auftreten, ohne den Bypass auszulösen. Erst wenn die Arbeitsspannung so stark abgefallen ist, dass sie die ebenfalls abfallende Modellspannung übertritt, wird von einem Spannungszusammenbruch ausgegangen. Unter Übertreten wird im Folgenden sowohl ein Übertreten in jedwede Richtung als auch nur ein Erreichen verstanden, wobei insbesondere gemeint ist, dass der zeitliche Verlauf der Arbeitsspannung die Modellspannung von oben her erreicht und insbesondere von oben nach unten kreuzt, also unterschreitet.

Ein weiterer Vorteil der Verwendung der Modellspannung als kritisches Charakteristikum liegt darin, dass eine große Freiheit hinsichtlich einstellbarer Variablen erreicht werden, sodass das Erkennen des Zusammenbruchs der Arbeitsspannung in einfacher Weise an viele unterschiedliche Arbeitssituationen anpassbar ist.

Das Übertreten kann überwacht werden, indem die Arbeitsspannung mit der Modellspannung über die Zeit verglichen wird. Dies kann punktuell, zeitlich periodisch oder kontinuierlich erfolgen, je nach Überwachungsschaltung. Als Zusammenbruch kann ein Spannungsabfall der Arbeitsspannung über das elektrische Bauelement verstanden werden, der schneller ist, als es im regulären Betrieb möglich und/oder zulässig ist. Der Spannungsabfall muss nicht zwangsläufig bis auf Null sein. Der Spannungszusammenbruch kann durch eine Fehlschaltung eines Schalters erfolgen, der beispielsweise einen Kurzschluss auslöst. Der Zusammenbruch der Arbeitsspannung über das elektrische Bauelement kann zu einer Überstromsituation in der elektrischen Baueinheit führen, also zu einem Stromfluss, der höher als im regulären Betrieb möglich und/oder zulässig ist.

Die überwachte Arbeitsspannung kann direkt die Spannung über das Bauelement sein oder eine Messspannung, die aus der Spannung über das Bauelement abgeleitet wird, z.B. durch einen Spannungsteiler. Sie ist zweckmäßigerweise proportional zur Spannung über das Bauelement. Der Einfachheit halber wird auch die aus der Spannung über das Bauelement abgeleitete Messspannung als Arbeitsspannung bezeichnet. Die Verwendung einer Messspannung bzw. die indirekte Messung der Arbeitsspannung ist insbesondere bei einer hohen Spannung über das Bauelement im Kilovoltbereich vorteilhaft, da auf diese Weise ein direkter Vergleich mit der Modellspannung, die besonders einfach im Bereich von nur wenigen Volt erzeugbar ist, möglich ist.

Als ein Erkennen des Zusammenbruchs kann eine Folgehandlung verstanden werden, die kausal in Abhängigkeit des Übertretens eingeleitet wird. Sie kann ein Signal an einem Vergleicher oder einem Sensor sein. Zweckmäßigerweise wird bei einem Erkennen des Übertretens eine Handlung eingeleitet, die den durch den Spannungsabfall erzeugten Stromfluss umleitet.

Erfindungsgemäß ist das elektrische Bauelement ein Kondensator. Die Erfindung kann so auch als ein Verfahren zur Erkennung einer Entladung eines Kondensators bezeichnet werden, bei dem die Arbeitsspannung über den Kondensator auf das Übertreten des kritischen Charakteristikums überwacht wird.

In einer vorteilhaften Ausführungsform der Erfindung erzeugt die Modellschaltung die Modellspannung aus der Arbeitsspannung. Die Modellschaltung kann aus der Arbeitsspannung versorgt werden und somit frei von einer externen Spannungsversorgung sein. Hierdurch kann die Modellschaltung beziehungsweise ihre Stromversorgung sehr einfach gehalten werden. Zweckmäßigerweise hebt die Arbeitsspannung die Modellspannung unmittelbar an, sodass ein Anheben der Arbeitsspannung auch zu einem Anheben der Modellspannung führen kann. Hierbei kann die Modellspannung von der Arbeitsspannung unmittelbar angehoben werden. Zweckmäßigerweise ist die Modellspannung so an die Arbeitsspannung gekoppelt, dass ein Steigen oder Absinken der Arbeitsspannung zu einem Steigen bzw. Absinken der Modellspannung führen, wobei die Modellspannung zweckmäßigerweise um einen Störabstand unter der Arbeitsspannung liegt, der einem fehlerhaften Erkennen eines Zusammenbruchs entgegenwirkt. Der Störabstand zwischen den beiden Spannungen ist zweckmäßigerweise abhängig von der Höhe der Arbeitsspannung.

Durch den Störabstand kann erreicht werden, dass ein fehlerhaftes Auslösen bei einer zulässigen Schwankung der Arbeitsspannung mit zeitweise hohem Spannungsgradient vermieden wird.

Erfindungsgemäß triggert ein Beginnen eines Absinkens der Arbeitsspannung einen Beginn des Absinkens der Modellspannung. Hierbei ist es vorteilhaft, wenn die Modellspannung in der Weise von der Arbeitsspannung abhängig ist, dass sie bei einem Absinken der Arbeitsspannung ebenfalls absinkt, jedoch nie steiler als mit einer Modellrate. Die Modellrate ist zweckmäßigerweise unabhängig von der Rate des Absinkens der Arbeitsspannung. Als Rate kann ein Gradient der Spannung über die Zeit gesehen werden.

In einer besonders vorteilhaften, weil einfachen Ausgestaltung der Erfindung ist die Modellschaltung eine Hardwareschaltung, die die Modellspannung allein aus Hardwareelementen erzeugt, insbesondere aus der Arbeitsspannung. Die Modellschaltung kann elektronikfrei sein, also frei von elektronischen Steuerungsprozessen und ist beispielsweise aus nur wenigen elektrischen Bauelementen, wie Kondensatoren, ohmschen Widerständen, Dioden und/oder Transistoren gebildet, wobei die Zahl zweckmäßigerweise 20 nicht überschreitet.

Ist das elektrische Bauelement ein Kondensator, so wird beim Erkennen des Zusammenbruchs zweckmäßigerweise ein Bypass geschlossen, durch den der Kondensator entladen wird. Die Arbeitsspannung, die proportional zur Spannung über den Kondensator ist, kann ohne weiter Schaden zu erzeugen, abgeführt werden.

Vorteilhafterweise wird die Modellspannung mit einem Anheben der Arbeitsspannung ebenfalls angehoben und ist durch die Modellschaltung von einem Absinken der Arbeitsspannung entkoppelt. Hierdurch kann die Modellspannung als Charakteristikum unabhängig von einer Sinkgeschwindigkeit der Arbeitsspannung die kritische Grenze vorgeben, ab der der Verlauf der Arbeitsspannung als Zusammenbruch gewertet werden muss.

Zum Entkoppeln können ein oder mehrere Dioden verwendet werden, durch die ein proportionales Anheben der Modellspannung mit der Arbeitsspannung ermöglicht wird, die jedoch das Absinken der Modellspannung vom Absinken der Arbeitsspannung trennt. Durch die Diode kann auch in einfacher Weise ein Störabstand eingestellt werden, also ein Spannungsunterschied, um den die Modellspannung von der Arbeitsspannung beabstandet ist, insbesondere tiefer liegt.

Vorteilhafterweise erfolgt das Absinken der Modellspannung unabhängig vom Verlauf des Absinkens der Arbeitsspannung mit einer von der Modellschaltung, insbesondere durch Hardware voreingestellten Sinkrate. Hierdurch kann eine besonders fehlerunanfällige und doch durch die Auswahl der Hardwarekomponenten einstellbare Zusammenbruchserkennung erfolgen. Die Absinkrate ist als absolute Größe zu verstehen, also als Volt pro Sekunde.

Weiter ist es vorteilhaft, wenn die von der Arbeitsspannung entkoppelte Absinkrate der Modellspannung abhängig von der Ausgangsspannung der Arbeitsspannung ist. Zweckmäßigerweise ist die Absinkrate umso höher, je höher die Ausgangsspannung ist.

Die Sinkrate der Modellspannung wird zweckmäßigerweise durch einen ohmschen Widerstand eingestellt, insbesondere in Verbindung mit einem Kondensator. Der Widerstand kann eine feste Größe sein, die die Sinkrate - ggf. abhängig von der Ausgangsspannung - festlegt. Eine hohe Variabilität kann erreicht werden, wenn der Widerstand einstellbar ist, beispielsweise durch eine Steuereinheit, insbesondere eine Steuerelektronik, die auch das Schalten des Bypass überwacht. Eine Einstellbarkeit der Größe des Widerstands kann einfach durch mehrere Zuschaltbare Einzelwiderstände erreicht werden, die in ihrer Gesamtheit den ohmschen Widerstand bilden. Die Zu- oder Wegschaltung kann durch die Steuereinheit erfolgen, beispielsweise in Abhängigkeit von unterschiedlichen Betriebsmodi des Umrichters. Die Betriebsmodi können in Abhängigkeit von der Ausgangsspannung der Arbeitsspannung oder von der maximal erreichten Arbeitspannung im regulären Betrieb eingestellt werden.

Die Erkennungszuverlässigkeit des Spannungszusammenbruchs kann weiter erhöht werden, wenn die Arbeitsspannung beim Übertreten des Charakteristikums durch ein Messelement deutlich über das Charakteristikum gedrückt wird. Die Arbeitsspannung, die zweckmäßigerweise proportional von der Spannung über das elektrische Bauelement abgeleitet ist, kann hierdurch zuverlässig und langfristig insbesondere unter die Modellspannung gezogen werden, sodass ein mehrfaches Kreuzen der Spannungen vermieden und dadurch auch eine Unsicherheit bei der Zusammenbruchserkennung vermieden wird.

Die Erfindung ist außerdem gerichtet auf ein Umrichtermodul mit einem elektrischen Bauelement und einem Überwacher zum Überwachen eines Verlaufs der Arbeitsspannung über das elektrische Bauelement auf das Übertreten eines kritischen Charakteristikums.

Es wird vorgeschlagen, dass der Überwacher erfindungsgemäß eine Modellschaltung zum Erzeugen einer Modellspannung und einem Vergleicher zum Vergleichen der Arbeitsspannung mit der Modellspannung und zur Ausgabe eines Signals aufweist, wenn die Arbeitsspannung die Modellspannung als kritisches Charakteristikum übertritt.

Vorteilhafterweise ist die Modellschaltung so ausgeführt, dass die Modellspannung an einem Ausgang anliegt, der mit der Arbeitsspannung, insbesondere über einen Störabstandserzeuger, also einem Spannungsbeabstander, so verbunden ist, dass die Arbeitsspannung die Modellspannung anhebt. Die Verbindung ist außerdem zweckmäßigerweise derart, dass ein Absinken der beiden Spannungen entkoppelt ist.

Erfindungsgemäß ist das elektrische Bauelement ein zwischen zwei Gleichstromzuleitungen eines Schalters angeordneter Kondensator. Je nach Stellrichtung können die Gleichstromzuleitungen auch Gleichstromableitungen des Schalters sein.

Besonders vorteilhaft ist die Erfindung anwendbar auf eine Umrichteranordnung, die als selbstgeführter HGÜ-Umrichter mit Transistoren und einem Spannungszwischenkreis ausgeführt ist, in der zweckmäßigerweise ein Kondensator als Ventil angeordnet ist.

Weiter ist die Erfindung vorteilhaft anwendbar bei einer Umrichteranordnung mit einer Anzahl von wie vorstehend beschriebenen Umrichtermodulen die in 2 x 3 Reihen geschaltet sind und die äußeren Anschlüsse von drei Reihenschaltungen jeweils eine Gleichspannungsseite bilden.

Die bisher gegebene Beschreibung vorteilhafter Ausgestaltungen der Erfindung enthält zahlreiche Merkmale, die in den einzelnen Unteransprüchen teilweise zu mehreren zusammengefasst wiedergegeben sind. Diese Merkmale können jedoch zweckmäßigerweise auch einzeln betrachtet und zu sinnvollen weiteren Kombinationen zusammengefasst werden. Insbesondere sind diese Merkmale jeweils einzeln und in beliebiger geeigneter Kombination sowohl mit dem erfindungsgemäßen Verfahren als auch mit dem erfindungsgemäßen Umrichtermodul gemäß den unabhängigen Ansprüchen kombinierbar. So sind Verfahrensmerkmale auch als Eigenschaft der entsprechenden Vorrichtungseinheit gegenständlich formuliert zu sehen und umgekehrt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Die Ausführungsbeispiele dienen der Erläuterung der Erfindung und beschränken die Erfindung nicht auf die darin angegebene Kombination von Merkmalen, auch nicht im Bezug auf funktionale Merkmale. Außerdem können dazu geeignete Merkmale eines jeden Ausführungsbeispiels auch explizit isoliert betrachtet und mit einem beliebigen der Ansprüche kombiniert werden.

Es zeigen:
- FIG 1: einen selbstgeführten HGÜ-Umrichter mit einer Vielzahl von HVDC-Powermodulen in Reihenschaltung,
- FIG 2: ein HVDC-Powermodul mit zwei Schaltern, einem Kondensator, einem Überwacher und einem Bypass,
- FIG 3: eine Schaltungsanordnung des Überwachers aus FIG 2 und
- FIG 4: den Verlauf der HV-Arbeitsspannung über den Kondensator aus FIG 2 und den Verlauf einer Modellspannung des Überwachers aus FIG 2 über die Zeit.

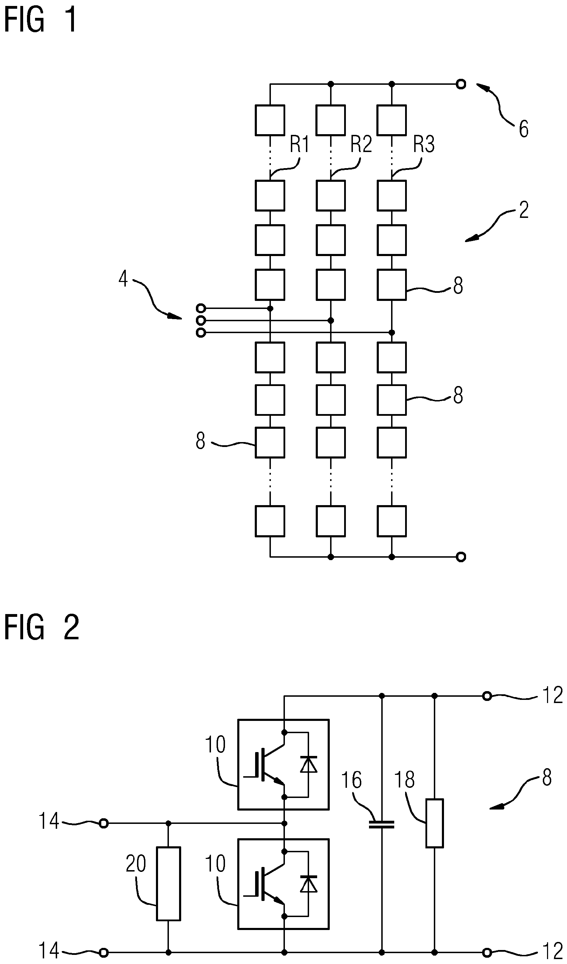

FIG 1 zeigt eine Umrichteranordnung 2 in Form eines selbstgeführten HGÜ-Umrichters zum Umrichten von Drehstrom an einem Drehstromeingang 4 in Gleichstrom an einen Gleichstromausgang 6 oder umgekehrt. Der Umrichter 2 weist eine Vielzahl von Umrichtermodulen 8 auf, die in Reihe geschaltet sind, sodass jede der drei Drehstromphasen des Drehstromeingangs 4 über jeweils eine Kette mit den beiden Gleichstromphasen des Gleichstromausgangs 6 verbunden ist. Durch die Anordnung der Umrichtermodule 8 in zwei mal drei parallel geschaltete Reihenschaltungen R1, R2, R3, bei denen die äußeren Anschlüsse die Gleichspannungsseite der Umrichteranordnung 2 bilden, kann Hochspannung mit hohen Stromstärken gerichtet werden.

Jeweils zwischen zwei einander spannungsmäßig entgegengesetzt geschalteten Reihenschaltungen R1, R2, R3 befindet sich ein Zwischenanschluss, der einen der drei Wechselspannungsanschlüsse des Drehstromeingangs 4 bildet, und also potentialmäßig zwischen den in FIG 1 oberen Umrichtermodulen 8 und den unteren Umrichtermodulen 8 der beiden Reihenschaltungen R1, R2, R3 liegt.

Die Umrichtermodule 8 der Umrichteranordnung 2 sind identisch ausgeführt und in FIG 2 detaillierter dargestellt. Jedes Umrichtermodul 8 umfasst zwei Schalter 10, die jeweils als IGBT ausgeführt sind und zur Schaltung von Strömen im kA-Bereich und Spannungen im kV-Bereich ausgelegt sind. Die beiden Schalter 10 liegen potentialmäßig in Reihe zwischen den beiden Polen des Gleichspannungsausgangs 12, wobei ein Pol des Wechselstromeingangs 14 mit einem Pol des Gleichspannungsausgangs 12 angekoppelt ist und der andere Wechselstromeingang 14 potentialmäßig zwischen den beiden Schaltern 10 liegt.

Zwischen die beiden Pole des Gleichspannungsausgangs 12 - wobei Eingang und Ausgang entsprechend der Stromrichtung der Umrichtung zu verstehen sind - ist ein Kondensator 16 und ein Überwacher 18 geschaltet. Zwischen die beiden Pole des Wechselspannungsausgangs 14 ist ein Bypass 20 geschaltet. Der Bypass 20 enthält eine pyrotechnische Ladung zum Einschießen eines Stempels zum Kurzschließen der beiden Pole des Wechselspannungsausgangs 14 im Fehlerfall des Umrichtermoduls 8. Angesteuert wird der Bypass 20 vom Überwacher 18, der einen Fehlerfall erkennt, wie beispielsweise das Freischalten beider Schalter 10 gleichzeitig, sodass sich der Kondensator 16 über die beiden Schalter 10 in einem internen Kurzschluss entlädt. Der Überwacher steuert dann den Bypass 18 an, sodass das Umrichtermodul 8 überbrückt und aus der Reihenschaltungen R1, R2, R3 herausgenommen wird. Eine Steuerelektronik erkennt den Fehler bzw. den Ausfall des Umrichtermoduls 8 und steuert die übrigen Umrichtermodule 8 der Reihenschaltungen R1, R2, R3 entsprechend an, dass die Stromumrichtung im ordentlichen Betrieb weitergeführt wird. Alternativ ist es denkbar, den Bypass 20 zwischen die beiden Pole des Gleichspannungsausgangs 12 zu schalten, so dass sich der Kondensator 16 bevorzugt über den Bypass 20 entlädt.

Die Schaltung in FIG 2 ist nur beispielhaft für eine Vielzahl von Möglichkeiten, bei denen eine Arbeitsspannung über ein elektrisches Bauelement, wie beispielhaft über den Kondensator 16 aus FIG 2, zusammenbrechen kann und durch einen Überwacher, wie beispielsweise den Überwacher 18 aus FIG 2 erkannt wird, sodass schützende Maßnahmen eingeleitet werden können. Insofern ist die Erfindung nicht auf eine Anordnung wie in FIG 2 beschränkt.

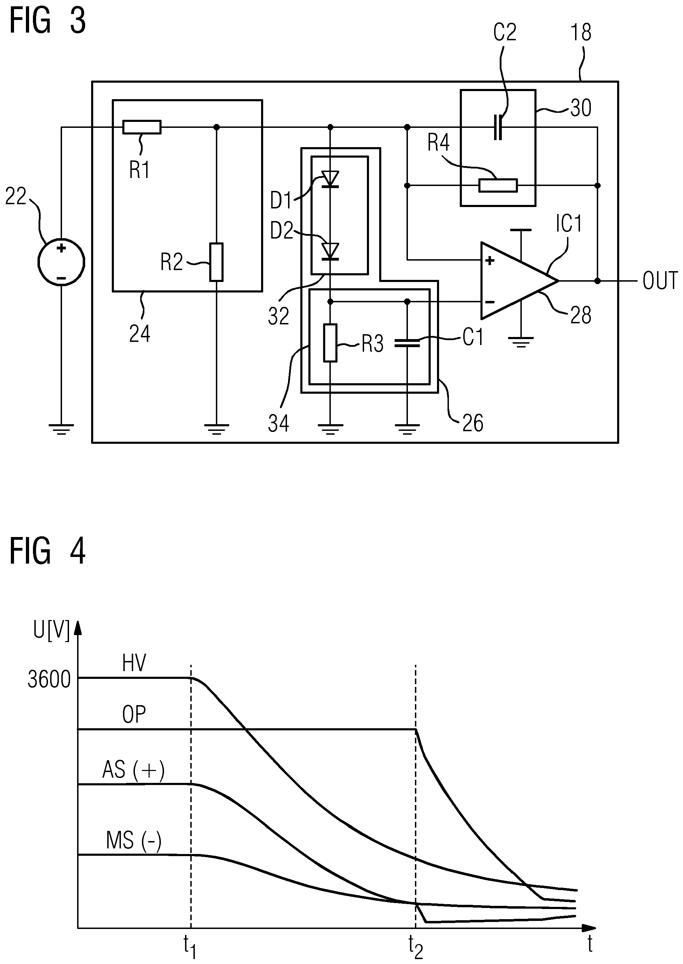

Eine beispielhafte Schaltung des Überwachers 18 ist in FIG 3 dargestellt. Beispielhaft ist ein elektrisches Bauelement 22 dargestellt, über dem eine Arbeitsspannung anliegt. Das elektrische Bauelement 22 kann der Kondensator 16 oder ein anderes Bauelement sein. Beispielhaft in FIG 3 ist ebenfalls, dass der eine Pol der Arbeitsspannung über das Bauelement 22 geerdet ist. Dies muss nicht unbedingt sein und ist auch in der Ausführungsform aus FIG 2 anders.

Der Überwacher 18 enthält einen Spannungsteiler 24, eine Modellschaltung 26, einen Vergleicher 28 und eine Zusatzbeschaltung 30 für den Vergleicher 28, die einen Booster C2 und einen Stabilisator R4 für den Vergleicher 28 enthält. Der Spannungsteiler 24 dient dazu, die Arbeitsspannung zu reduzieren, sodass sie auf einem leichter zu vergleichenden Niveau liegt. Auch diese reduzierte Arbeitsspannung wird - ob schon geringer als die über dem elektrischen Bauelement 22 anliegende Arbeitsspannung - ebenfalls als Arbeitsspannung bezeichnet, und sie ist zweckmäßigerweise stets proportional zu der Arbeitsspannung über dem elektrischen Bauelement 22, ggf. etwas durch einen Störabstand verschoben. Der Spannungsteiler 24 enthält zwei ohmsche Widerstände R1, R2, mit denen die Spannungsteilung, also das Niveau der reduzierten Arbeitsspannung, eingestellt werden kann. So wird die Arbeitsspannung von beispielsweise 3600 V auf über dem elektrischen Bauelement 22 auf beispielsweise unter 20 V im Überwacher 18 reduziert.

Die Modellschaltung 26 dient dazu, eine Modellspannung zu erzeugen. Im gezeigten Ausführungsbeispiel wird die Modellspannung direkt aus der reduzierten Arbeitsspannung erzeugt, indem diese Arbeitsspannung an der Modellschaltung 26 anliegt. Die Modellspannung liegt hierbei stets unter der Arbeitsspannung, wobei ein Pol der Modellspannung mit einem Pol der Arbeitsspannung verbunden sein kann, wie in dem Ausführungsbeispiel aus FIG 3 beispielhaft durch die Erdung realisiert ist.

Die Modellspannung weist zwei Unterschiede zur Arbeitsspannung auf. Erstens ist sie um eine Störspannung oder einen Störabstand niedriger als die Arbeitsspannung. Zweitens ist sie von einer stark absinkenden Arbeitsspannung entkoppelt. Beabstandung und Entkopplung können von zwei verschiedenen Baueinheiten, einem Beabstander und einem Entkoppler, vorgenommen werden. Es ist jedoch auch möglich, beide Funktionen durch eine Baueinheit vorzunehmen, wie dies beispielhaft in FIG 3 durch den Entkoppler 32 gezeigt ist, der aus zwei Dioden D1, D2 gebildet ist. Eine andere Möglichkeit besteht darin, den Entkoppler 32 aus einem odere mehrere Transistoren zu bilden. Hierdurch kann die Entkopplung verbessert werden, die Beabstandung entfällt jedoch im Wesentlichen, sodass hierfür ein separater Beabstander sinnvoll ist. Ein Kompromiss aus beiden Varianten kann erzielt werden, wenn der Entkoppler 32 nur eine Diode und einen Transistor enthält, wobei die Diode den Spannungsabstand einstellt und der Transistor im Wesentlichen zur Entkopplung dient.

Zur Erzeugung der Modellspannung enthält die Modellschaltung 26 außerdem einen Gradientenbilder 34, der den Spannungsabfall der Modellspannung über die Zeit festlegt. Das Spannungsmodell wird bei der Modellschaltung 26 aus FIG 3 durch einen ohmschen Widerstand R3 und einem Kondensator C1 erzeugt. Bei einem sehr schnellen Absinken der Arbeitsspannung und einem Entkoppeln des Gradientbilders 34 von der Arbeitsspannung durch den Entkoppler 32 dient der Kondensator C1 als Energiequelle, deren Energie durch den ohmschen Widerstand R3 mit der Zeit abgebaut wird, wodurch die Modellspannung sinkt.

Hierbei wird die Absinkrate beziehungsweise der negative Spannungsgradient in seinem maximalen Verlauf festgelegt, der schnellstmögliche Abfall der Modellspannung wird also durch den Gradientenbilder 34 bestimmt. Ein langsamerer Verlauf des Spannungsabfalls ist immer möglich und wird durch den Entkoppler 32 mitbestimmt. Wenn jedoch die Arbeitsspannung sehr schnell abfällt, so ist der Abfall der Modellspannung durch den Gradientbilder 34 beschränkt. Diese Beschränkung bildet keinen Absolutwert des Spannungsabfalls beziehungsweise des Gradienten, da dieser vor der Ausgangsgröße der Modellspannung beziehungsweise der Arbeitsspannung abhängt. Je größer der Ausgangswert der Modellspannung ist, desto größer wird auch der maximale negative Gradient sein.

Während der Entkoppler 32 also die Modellspannung von einem sehr schnellen Abfallen der Arbeitsspannung entkoppelt, bindet der Entkoppler 32 die Modellspannung an eine ansteigende oder gleichbleibende Arbeitsspannung an. Steigt also die Arbeitsspannung, so steigt auch die Modellspannung. Sinkt die Arbeitsspannung nur langsam, so sinkt auch die Modellspannung langsamer als bei maximal möglichem Absinken. Verharrt die Arbeitsspannung auf einem Wert, so bleibt auch die Modellspannung - nach einem kurzen Einstellvorgang - konstant.

Der Vergleicher 28 ist in diesem Ausführungsbeispiel ein Operationsverstärker, an dessen beiden Eingängen die Modellspannung beziehungsweise die Arbeitsspannung anliegt. Bei diesem Ausführungsbeispiel liegt die Arbeitsspannung am positiven Eingang und die Modellspannung am negativen Eingang des Operationsverstärkers beziehungsweise Vergleichers 28 an. Die Zusatzbeschaltung 30 des Vergleichers 28 enthält einen Stabilisator in Form eines ohmschen Widerstands R4 und einen Buster in Form eines Kondensators C2.

Ein Erkennungsprozess eines Zusammenbruchs der Arbeitsspannung wird anhand des Diagramms aus FIG 4 beispielhaft erläutert. Das Diagramm zeigt die Spannung U in Volt über die Zeit t. Im gezeigten Ausführungsbeispiel ist die Arbeitsspannung HV über das elektrische Bauelement 22 3600 V und ist in FIG 4 mit HV (High Voltage) bezeichnet. Die reduzierte Arbeitsspannung AS wird durch den Spannungsteiler 24 auf beispielsweise 12 V reduziert. Da es im Sinne der Erfindung unbedeutend ist, ob die Arbeitsspannung HV über das elektrische Bauelement 22 direkt über indirekt über die reduzierte Arbeitsspannung AS überwacht wird, wird auch die reduzierte Arbeitsspannung AS als Arbeitsspannung HV über das elektrische Bauelement 22 bezeichnet.

Die in FIG 4 gezeigten Spannungsverläufe sind nicht proportional zueinander dargestellt, sondern in ihrer Höhe so verteilt, dass die Beziehungen der Verläufe deutlich werden. So kann die reduzierte Arbeitsspannung AS - je nach Höhe der Hochspannung HV über oder unter dem Ausgang OP des Vergleichers 28 von 15 V liegen. Auch der Störabstand der Modellspannung MS von der reduzierten Arbeitsspannung AS kann im Wesentlich frei eingestellt und damit an die Einsatzsituation angepasst werden.

Der zeitliche Verlauf der reduzierten Arbeitsspannung AS ist an den zeitlichen Verlauf der Hochspannung HV über das elektrische Bauelement 22 in vorbestimmter Weise gekoppelt. Bei konstanter Hochspannung HV ist auch die Arbeitsspannung AS konstant. Dies ist in FIG 4 bis zum Zeitpunkt t₁ gegeben. Bei diesem Zeitpunkt t₁ bricht die Hochspannung HV über dem elektrischen Bauelement 22, also die Hochspannung HV von 3600 V, zusammen. Das Diagramm in FIG 4 zeigt eine Zeitspanne von nur wenigen Millisekunden, sodass die Hochspannung HV nicht mit einem senkrechten Strich nach unten abfällt, sondern ein kontinuierlicher und stetiger Abfall der Hochspannung HV erkennbar ist.

Das Absinken der Modellspannung MS ist durch den Gradientbilder 34 so eingestellt, dass die Arbeitsspannung AS die Modellspannung MS im regulären Betrieb der Umrichteranordnung 2 nicht erreicht. Das Übertreten der Arbeitsspannung AS über die Modellspannung MS ist somit im regulären Betrieb nicht möglich, sondern nur bei einem Zusammenbrechen der Arbeitsspannung AS durch einen fehlerhaften Betriebszustand.

Vom Zeitpunkt t₁ beginnt das Zusammenbrechen der Hochspannung HV über dem elektrischen Bauelement 22. Entsprechend beginnt auch das Absinken der Arbeitsspannung AS zum gleichen Zeitpunkt t₁. Durch den Entkoppler 32 wird das Zusammenbrechen der Arbeitsspannung AS von dem Absinken der Modellspannung MS entkoppelt, sodass die Modellspannung MS mit dem durch den Gradientenbilder 34 gebildeten Gradienten absinkt. Dieses Absinken ist unabhängig von dem Gradienten der Arbeitsspannung AS.

Zum Startpunkt des Zusammenbrechens der Arbeitsspannung AS sind die Modellspannung MS und die Arbeitsspannung AS durch einen Störabstand - im Ausführungsbeispiel aus FIG 4 beispielsweise 3 V - voneinander beabstandet. Durch den Störabstand wird verhindert, dass sich die beiden Spannungen AS, MS durch ungewünschte, die Spannung beeinflussende Effekte unbeabsichtigter Weise treffen beziehungsweise kreuzen.

Das Absinken der Hochspannung HV über das elektrische Bauelement 22 erfolgt hierbei schneller als es im regulären Betrieb möglich beziehungsweise zulässig ist. Da der negative Gradient der Arbeitsspannung AS größer als der negative Gradient der Modellspannung MS ist, nähert sich die Arbeitsspannung AS im Verlauf der Zeit an die Modellspannung MS an. Zum Zeitpunkt t₂ erreicht die Arbeitsspannung AS die Modellspannung MS, wie in FIG 4 dargestellt ist. Da die Arbeitsspannung AS am positiven Eingang + des Vergleichers 28 anliegt und die Modellspannung MS am negativen Eingang -, reagiert der Vergleicher 28 beim Wegfall des Störabstands mit einem entsprechenden Signal, das auch als Erkennen des Zusammenbruchs der Arbeitsspannung AS bezeichnet werden kann.

Das Signal OP des Vergleichers 28 ist in diesem Ausführungsbeispiel ein schnelles Absinken der Spannung am Ausgang des Vergleichers 28 bei einem Verschwinden des Störabstands zum Zeitpunkt t₂. Durch dieses Signal wird nun der Bypass 20 angesteuert und der Kurzschluss des Bypasses 20 zwischen den beiden Polen des Gleichspannungsausgangs 12 geschlossen. Die Arbeitsspannung AS wird somit auf das Übertreten der Modellspannung MS als kritisches Charakteristikum überwacht und das Übertreten zum Zeitpunkt t₂ wird als Zusammenbruch der Arbeitsspannung AS erkannt.

Außerdem ist der Ausgang des Vergleichers 28 über die Zusatzbeschaltung 30 mit der Arbeitsspannung AS verbunden. Das starke Absinken der Vergleicherspannung OP zieht auch die Arbeitsspannung AS nach unten, wie in FIG 4 sichtbar ist. Diese kreuzt somit deutlich die Modellspannung MS, sodass ein Springen der Vergleicherspannung OP vermieden wird.

Im Betrieb des Umrichters 8 kann es vorkommen, dass der Umrichter - bedingt durch unterschiedliche Betriebsmodi der Umrichteranordnung 2 - mit unterschiedlichen maximalen Arbeitsspannungen AS beaufschlagt wird. Dann kann es vorteilhaft sein, wenn die Sinkrate in Abhängigkeit des jeweiligen Betriebsmodus eingestellt werden kann, die Sinkrate also nicht nur von der maximalen Arbeitsspannung AS abhängig ist, sondern zusätzlich vom aktuellen Betriebsmodus. Da die Sinkrate der Modellspannung MS durch den Widerstand R3 einstellbar ist - je größer der Widerstand R3 ist, desto geringer ist die Sinkrate - ist es vorteilhaft, wenn anstelle eines festen Widerstands ein einstellbarer Widerstand R3 vorhanden ist. Beispielsweise enthält der Widerstand R3 eine Mehrzahl von einzeln zuschaltbaren Widerstandseinheiten, die von einer Steuereinheit, z.B. der Steuerelektronik, in Abhängigkeit vom aktuellen Betriebsmodus zu bzw. weggeschaltet werden können.

### Bezugszeichenliste

- 2: Umrichteranordnung
- 4: Drehstromeingang
- 6: Gleichstromausgang
- 8: Umrichtermodul
- 10: Schalter
- 12: Gleichspannungsausgang
- 14: Wechselstromeingang
- 16: Kondensator
- 18: Überwacher
- 20: Bypass
- 22: elektrisches Bauelement
- 24: Spannungsteiler
- 26: Modellschaltung
- 28: Vergleicher
- 30: Zusatzbeschaltung
- 32: Entkoppler
- 34: Gradientbilder
- AS: Arbeitsspannung
- C1-C2: Kondensator
- D1-D2: Diode
- HV: Hochspannung
- MS: Modellspannung
- OP: Ausgangssignal
- R1-R4: Widerstand

## Patentansprüche

1. Verfahren zur Erkennung eines Zusammenbruchs einer Arbeitsspannung (HV, AS) über einem elektrischen Bauelement (22), das ein Kondensator ist, wobei bei dem Verfahren die Arbeitsspannung (HV, AS) auf das Übertreten eines kritischen Charakteristikums überwacht und ein Übertreten als Zusammenbruch erkannt wird, wobei eine von einer Modellschaltung (26) erzeugte Modellspannung (MS) als kritisches Charakteristikum verwendet wird, wobei ein beginnendes Absinken der Arbeitsspannung (HV, AS) einen Beginn eines Absinkens der Modellspannung (MS) triggert.

2. Verfahren nach Anspruch 1,
**dadurch gekennzeichnet, dass**
die Modellschaltung (26) die Modellspannung (MS) aus der Arbeitsspannung (HV, AS) erzeugt.

3. Verfahren nach einem der vorhergehenden Ansprüche,
**dadurc hgekennzeichnet**, dass
die Modellschaltung (26) eine Hardwareschaltung ist, die die Modellspannung (MS) allein aus Hardwareelementen aus der Arbeitsspannung (HV, AS) erzeugt.

4. Verfahren nach Anspruch 1,
**dadurch gekennzeichnet, dass**
beim Erkennen des Zusammenbruchs ein Bypass (20) geschlossen wird, durch den der Kondensator (16) entladen wird.

5. Verfahren nach einem der vorhergehenden Ansprüche,
**dadurch gekennzeichnet, dass**
die Modellspannung (MS) mit einem Anheben der Arbeitsspannung (HV, AS) ebenfalls angehoben wird und durch die Modellschaltung (26) von einem Absinken der Arbeitsspannung (HV, AS) entkoppelt ist.

6. Verfahren nach einem der vorhergehenden Ansprüche,
**dadurch gekennzeichnet, dass** das Absinken der Modellspannung (MS) unabhängig vom Verlauf des Absinkens der Arbeitsspannung (HV, AS) mit einer von der Modellschaltung (26) durch Hardware voreingestellten Sinkrate erfolgt.

7. Verfahren nach Anspruch 6 **dadurch gekennzeichnet, dass**
die von der Arbeitsspannung (HV, AS) entkoppelte Sinkrate der Modellspannung (MS) abhängig von der Ausgangsspannung der Arbeitsspannung (HV, AS) ist.

8. Verfahren nach einem der vorhergehenden Ansprüche,
**dadurch gekennzeichnet, dass**
die Arbeitsspannung (AS) beim Übertreten des Charakteristikums durch ein Messelement deutlich über das Charakteristikum gedrückt wird.

9. Verfahren nach einem der vorhergehenden Ansprüche,
**dadurch gekennzeichnet, dass**
die Modellspannung (MS) durch zumindest eine Diode (D1, D2) von einem Absinken der Arbeitsspannung (AS) entkoppelt ist.

10. Verfahren nach einem der vorhergehenden Ansprüche,
**dadurch gekennzeichnet, dass**
die Modellspannung (MS) im Ausgangszustand durch einen Störabstand von der Arbeitsspannung (AS) beabstandet ist.

11. Umrichtermodul (8) mit einem elektrischen Bauelement (22) und einem Überwacher (18) zum Überwachen eines Verlauf einer Arbeitsspannung (HV, AS) über das elektrische Bauelement (22) auf das Übertreten eines kritischen Charakteristikums,
wobei der Überwacher (18) eine Modellschaltung (26) zum Erzeugen einer Modellspannung(MS) und einen Vergleicher (28) zum Vergleichen der Arbeitsspannung (HV, AS) mit der Modellspannung (MS) und zur Ausgabe eines Signals aufweist, wenn die Arbeitsspannung (HV, AS) die Modellspannung (MS) als kritisches Charakteristikum übertritt, wobei das elektrische Bauelement (22) ein zwischen zwei Gleichstromzuleitungen (12) eines Schalters (10) angeordneten Kondensator (16) ist, wobei der Überwacher derart ausgestaltet ist, dass ein beginnendes Absinken der Arbeitsspannung (HV, AS) einen Beginn eines Absinkens der Modellspannung (MS) triggert.

12. Umrichteranordnung (2) mit einer Anzahl von Umrichtermodulen (8) nach Anspruch 11,
**dadurch gekennzeichnet, dass**
die Umrichtermodule (8) in 2 x 3 Reihen geschaltet sind und die äußeren Anschlüsse von drei Reihenschaltungen (R1, R2, R3) jeweils eine Gleichspannungsseite bilden.

## Claims

1. Method for detecting a collapse of a working voltage (HV, AS) across an electrical component (22), which component is a capacitor, in which method the working voltage (HV, AS) is monitored for the crossing of a critical characteristic and a crossing is detected as a collapse, wherein a model voltage (MS) generated by a model circuit (26) is used as critical characteristic, wherein an incipient drop in the working voltage (HV, AS) triggers the model voltage (MS) to start to drop.

2. Method according to Claim 1, **characterized in that** the model circuit (26) generates the model voltage (MS) from the working voltage (HV, AS).

3. Method according to either of the preceding claims, **characterized in that** the model circuit (26) is a hardware circuit that generates the model voltage (MS) from the working voltage (HV, AS) using only hardware elements.

4. Method according to Claim 1, **characterized in that**, on detecting a collapse, a bypass (20) is closed through which the capacitor (16) is discharged.

5. Method according to one of the preceding claims, **characterized in that** as the working voltage (HV, AS) increases so the model voltage (MS) is also increased and is decoupled from a drop in the working voltage (HV, AS) by the model circuit (26).

6. Method according to one of the preceding claims, **characterized in that** the drop in the model voltage (MS) takes place independently of the profile of the drop in the working voltage (HV, AS) with a drop rate preset by the model circuit (26) using hardware.

7. Method according to Claim 6, **characterized in that** the drop rate of the model voltage (MS) that is decoupled from the working voltage (HV, AS) is dependent on the initial voltage of the working voltage (HV, AS).

8. Method according to one of the preceding claims, **characterized in that**, on crossing the characteristic, the working voltage (AS) is forced substantially above the characteristic by a measuring element.

9. Method according to one of the preceding claims, **characterized in that** the model voltage (MS) is decoupled from a drop in the working voltage (AS) by at least one diode (D1, D2) .

10. Method according to one of the preceding claims, **characterized in that**, in the initial state, the model voltage (MS) is spaced apart from the working voltage (AS) by a noise margin.

11. Converter module (8) with an electrical component (22) and a monitoring unit (18) for monitoring a profile of a working voltage (HV, AS) across the electrical component (22) for the crossing of a critical characteristic, wherein the monitoring unit (18) has a model circuit (26) for generating a model voltage (MS) and a comparator (28) for comparing the working voltage (HV, AS) with the model voltage (MS) and for issuing a signal if the working voltage (HV, AS) crosses the model voltage (MS) as a critical characteristic, wherein the electrical component (22) is a capacitor (16) positioned between two DC supply lines (12) of a switch (10), wherein the monitoring unit is designed such that an incipient drop in the working voltage (HV, AS) triggers the model voltage (MS) to start to drop.

12. Converter arrangement (2) with a number of converter modules (8) according to Claim 11, **characterized in that** the converter modules (8) are connected in 2 x 3 series and the external connections of three series circuits (R1, R2, R3) each form a DC voltage side.

## Revendications

1. Procédé de reconnaissance d'un effondrement d'une tension (HV, AS) de travail aux bornes d'un composant (22) électrique, qui est un condensateur, procédé dans lequel on contrôle le franchissement, par la tension (HV, AS) de travail, d'une caractéristique critique et on reconnaît un franchissement comme un effondrement, dans lequel on utilise, comme caractéristique critique, une tension (MS) de modèle produite par un circuit (26) modèle, un abaissement commençant de la tension (HV, AV) de travail déclenchant un début d'un abaissement de la tension (MS) de modèle.

2. Procédé suivant la revendication 1,
**caractérisé en ce que**
le circuit (26) modèle produit la tension (MS) de modèle à partir de la tension (HV, AS) de travail.

3. Procédé suivant l'une des revendications précédentes,
**caractérisé en ce que**
le circuit (26) modèle est un circuit matériel, qui produit, à partir de la tension (HV, AS) de travail, la tension (MS) de modèle seulement à partir d'élément matériel.

4. Procédé suivant la revendication 1,
**caractérisé en ce que**
lorsque l'on reconnaît l'effondrement, on ferme une dérivation (20), dans laquelle on décharge le condensateur (16).

5. Procédé suivant l'une des revendications précédentes,
**caractérisé en ce que**
l'on élève également la tension (MS) de modèle par une élévation de la tension (HV, AS) de travail et par le circuit (26) modèle, elle est découplée d'un abaissement de la tension (HV, AS) de travail.

6. Procédé suivant l'une des revendications précédentes,
**caractérisé en ce que**
l'abaissement de la tension (MS) de modèle a lieu indépendamment de la courbe d'abaissement de la tension (HV, AS) de travail à un taux d'abaissement réglé à l'avance par matériel par le circuit (26) modèle.

7. Procédé suivant la revendication 6,
**caractérisé en ce que**
le taux d'abaissement, découplé de la tension (HV, AS) de travail, de la tension (MS) de modèle dépend de la tension de sortie de la tension (HV, AS) de travail.

8. Procédé suivant l'une des revendications précédentes,
**caractérisé en ce que**
la tension (AS) de travail est, lors du franchissement de la caractéristique, poussée par un élément de mesure nettement au-dessus de la caractéristique.

9. Procédé suivant l'une des revendications précédentes,
**caractérisé en ce que**
la tension (MS) de modèle est, par au moins une diode (D1, D2), découplée d'un abaissement de la tension (AS) de travail.

10. Procédé suivant l'une des revendications précédentes,
**caractérisé en ce que**
la tension (MS) de modèle est, dans l'état initial, à distance, d'une distance de perturbation, de la tension (AS) de travail.

11. Module (8) de convertisseur, comprenant un composant (22) électrique et un contrôleur (18), pour contrôler une courbe d'une tension (HV, AS) de travail aux bornes du composant (22) électrique par le franchissement d'une
caractéristique critique,
dans lequel le contrôleur (18) a un circuit (26) modèle d'une production d'une tension (MS) de modèle et un comparateur (28) de comparaison de la tension (HV, AS) de travail à la tension (MS) de modèle et pour l'émission d'un signal, si la tension (HV, AS) de travail franchit la tension (MS) de modèle comme caractéristique critique, le composant (22) électrique étant un condensateur (16) monté entre deux lignes (12) de courant continu d'un interrupteur (10), le contrôleur étant conformé de manière à ce qu'un abaissement débutant de la tension (HV, AS) de travail déclenche un début d'un abaissement de la tension (MS) de modèle.

12. Agencement (2) de convertisseur, ayant un certain nombre de modules (8) de convertisseur suivant la revendication 11,
**caractérisé en ce que**
les modules (8) de convertisseur sont montés en 2 × 3 rangées et les bornes extérieures de trois circuits (R1, R2, R3) série forment chacune un côté de tension continue.
